# EUROPÄISCHE PATENTANMELDUNG

(11) **EP 1 645 610 A1**
(43) Veröffentlichungstag der Anmeldung: **12.04.2006**
(21) Anmeldenummer: 04024204.2
(22) Anmeldetag: 11.10.2004
(51) Int. Cl.: C09K 11/06, H01L 51/30, H05B 33/14

(54) **Phenanthren-Derivate**

(71) Anmelder: Covion Organic Semiconductors GmbH, 65926 Frankfurt am Main (DE)
(72) Erfinder: Die Erfindernennung liegt noch nicht vor

(57) **Zusammenfassung**

Die vorliegende Erfindung betrifft die Verbesserung organischer Elektrolumineszenzvorrichtungen, insbesondere blau emittierender Vorrichtungen, indem Verbindungen gemäß Formel (1) als Hostmaterialien in der emittierenden Schicht verwendet werden.

## Beschreibung

Die vorliegende Erfindung beschreibt neuartige Phenanthren-Verbindungen und deren Verwendung in organischen Elektrolumineszenzvorrichtungen.

Der Einsatz halbleitender organischer Verbindungen, die zur Emission von Licht im sichtbaren Spektralbereich befähigt sind, in organischen Elektrolumineszenzvorrichtungen (OLEDs) steht gerade am Anfang der Markteinführung. Der allgemeine Aufbau solcher Vorrichtungen ist beispielsweise in US 4539507, US 5151629, EP 0676461 und WO 98/27136 beschrieben. Für einfache OLEDs enthaltende Vorrichtungen ist die Markteinführung bereits erfolgt, wie die Autoradios der Firma Pioneer, die Mobiltelefone der Firmen Pioneer und SNMD oder eine Digitalkamera der Firma Kodak mit "organischem Display" belegen. Weitere derartige Produkte stehen kurz vor der Einführung.

Allerdings zeigen diese Vorrichtungen immer noch erhebliche Probleme, die einer dringenden Verbesserung bedürfen:
1. Die operative Lebensdauer ist insbesondere bei blauer Emission immer noch zu gering, so dass bis dato nur einfache Anwendungen kommerziell realisiert werden konnten.
2. Die Effizienz ist in den letzten Jahren verbessert worden, ist aber gerade bei fluoreszierenden OLEDs immer noch zu niedrig und muss verbessert werden.
3. Die Betriebsspannung ist gerade bei fluoreszierenden -OLEDs recht hoch und sollte daher weiter verringert werden, um die Leistungseffizienz zu verbessern. Das ist insbesondere für mobile Anwendungen von großer Bedeutung.

Als Host-Material gemäß dem Stand der Technik sind Anthracen-Derivate, beispielsweise 2-Dinaphthylanthracen (US 5935721), bekannt. Weitere Anthracen-Derivate, die sich als Host-Materialien eignen, sind beispielsweise in WO 04/013073 oder in WO 04/018588 beschrieben. Host-Materialien, basierend auf arylsubstituierten Pyrenen und Chrysenen, werden in WO 04/016575 beschrieben. Diese Anmeldung umfasst prinzipiell auch entsprechende Anthracen- und Phenanthren-Derivate, jedoch sind diese in der Beschreibung nicht ausgeführt, so dass auch für den Fachmann nicht offensichtlich ist, welche dieser Derivate hierfür nutzbringend eingesetzt werden könnten.

Es wurde beobachtet, dass das Host-Material, das für den emittierenden Dotanden verwendet wird, eine entscheidende Rolle bei den Eigenschaften der organischen Elektrolumineszenzvorrichtung spielt. Daher sollte es möglich sein, durch weitere Optimierung des Host-Materials auch die Eigenschaften der OLED weiter zu verbessern.

Es besteht also weiterhin Bedarf an verbesserten Host-Materialien, die insbesondere zusammen mit blau emittierenden Verbindungen in organischen Elektrolumineszenzvorrichtungen zu guten Effizienzen und gleichzeitig zu hohen Lebensdauern führen. Es wurde nun überraschend gefunden, dass bestimmte - im Folgenden aufgeführte - Phenanthren-Derivate, aber auch Dihydrophenanthren-Derivate, Dihydropyren-Derivate oder Tetrahydropyren-Derivate, als Host für blau emittierende Dotanden oder auch als Emitter oder in anderen Funktionen deutliche Verbesserungen gegenüber dem Stand der Technik aufweisen. Mit diesen Materialien ist es möglich, gleichzeitig hohe Effizienzen und lange Lebensdauern zu erhalten. Außerdem sind diese Verbindungen leicht auch in großem Maßstab synthetisch zugänglich und weisen im Gegensatz zu vielen Phenanthren-Derivaten gemäß dem Stand der Technik eine gute Löslichkeit in einer großen Reihe organischer Lösemittel auf, so dass sie deutlich leichter zu reinigen sind als Materialien gemäß dem Stand der Technik. Die Substitution der Phenanthren-Einheiten in 9- bzw. 9,10-Position und die Anknüpfung der Aryl-Substituenten in der 2,7-Position hat sich überraschend als besonders geeignet im Vergleich zur Substitution in anderen Positionen der Phenanthren-Einheit erwiesen. Der Phenanthren-Grundkörper.und die Nummerierung der einzelnen Positionen ist der Übersichtlichkeit halber im Folgenden abgebildet, ebenso wie die Dihydrophenanthren-, Dihydropyren- und Tetrahydropyren-Grundkörper:

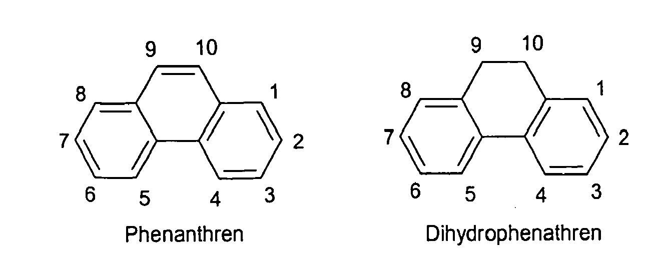

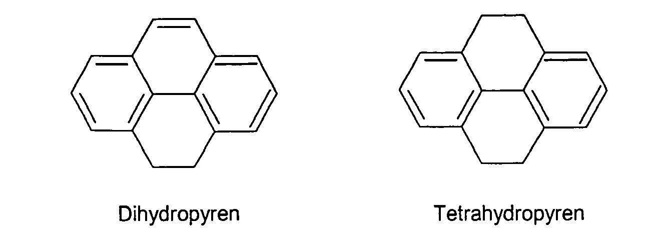

Ohne an eine bestimmte Theorie gebunden sein zu wollen, vermuten wir weiterhin, dass die Substitution in der 9- und/oder 10-Position zu einer verringerten Reaktivität dieser Positionen führt, was sich in der längeren Lebensdauer widerspiegelt. Weiterhin wird beobachtet, dass die Emission von Verbindungen, die in 2- und 7-Position aryl-substituiert sind, tiefer blau ist als die von entsprechend in 3- und 6-Position substituierten Verbindungen. Daher sind diese Materialien besser als Host-Materialien geeignet.

Die Verwendung von Phenanthrenen in OLEDs ist bereits in der Literatur beschrieben. So ist beispielsweise in WO 04/016575 3,6-Dinaphthylphenanthren neben anderen Verbindungen als Host-Material für blaue OLEDs abgebildet. Allerdings weist diese Verbindung die oben genannten Schwachpunkte - fehlende Substitution in 9,10-Position und nur hellblaue Emission durch Substitution in 3,6-Position - auf, so dass diese Verbindung als Hostmaterial nicht zu bevorzugen ist.
In US 5077142 wird die Verwendung bestimmter aryl-substituierter Aromaten, unter anderem Phenanthrene, in organischen Elektrolumineszenzvorrichtungen beschrieben. Aus der Beschreibung geht allerdings nicht hervor, welche der in der allgemeinen und sehr breiten Strukturformel beschriebenen Verbindungen sich für die Herstellung besonders guter Vorrichtungen eignet. Insbesondere findet sich kein Hinweis darauf, dass es sinnvoll ist, die 9- bzw. 9,10-Position zu substituieren. In JP 2001/332384 werden aryl-substituierte Phenanthrene für die Verwendung in OLEDs beschrieben. Hier werden unter anderem auch 3,6,9,10-tetraphenylsubstituierte Phenanthrene aufgeführt, die zwar gegenüber den oben aufgeführten Verbindungen durch die Substitution in 9,10-Position bevorzugt sind, jedoch immer noch den Nachteil der 3,6-Substitution und der dadurch nur hellblauen Emission aufweisen.

Gegenstand der Erfindung sind daher Verbindungen gemäß Formel (1), 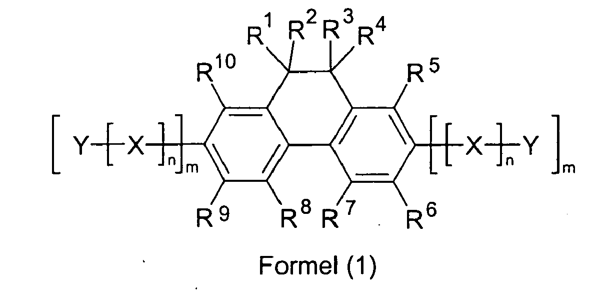 wobei die verwendeten Symbole und Indizes folgende Bedeutung besitzen:
- R¹, R³: ist bei jedem Auftreten gleich oder verschieden H, F, eine geradkettige, verzweigte oder cyclische Alkyl- oder Alkoxykette mit 1 bis 40 C-Atomen, die durch R¹¹ substituiert sein kann, in der auch ein oder mehrere nicht benachbarte C-Atome durch N-R¹¹, O, S, O-CO-O, CO-O, -CR¹¹=CR¹¹ -oder -C≡C- ersetzt sein können und in der auch ein oder mehrere H-Atome durch F, Cl, Br, I oder CN ersetzt sein können, oder ein aromatisches oder heteroaromatisches Ringsystem mit 2 bis 60 C-Atomen, welches auch durch einen oder mehrere Reste R¹¹ substituiert sein kann; mit der Maßgabe, dass mindestens einer der beiden Reste R¹ und R³ ungleich H ist;
- R² R⁴: ist bei jedem Auftreten gleich oder verschieden R¹, oder R² und R⁴ stehen nicht für Substituenten, sondern bilden miteinander eine π-Bindung, so dass sich statt des Dihydrophenanthren-Systems ein Phenanthren-System ergibt;
- R⁵, R⁶, R⁷, R⁸, R⁹, R¹⁰: ist bei jedem Auftreten gleich oder verschieden H, F, Cl, Br, I, eine geradkettige, verzweigte oder cyclische Alkyl- oder Alkoxykette mit 1 bis 40 C-Atomen, die durch R¹¹ substituiert sein kann, in der auch ein oder mehrere nicht benachbarte C-Atome durch N-R¹¹, O, S, O-CO-O, CO-O, -CR¹¹=CR¹¹- oder -C≡C- ersetzt sein können und in der auch ein oder mehrere H-Atome durch F, Cl, Br, I oder CN ersetzt sein können, oder ein aromatisches oder heteroaromatisches Ringsystem mit 2 bis 60 C-Atomen, welches auch durch einen oder mehrere Reste R¹¹ substituiert sein kann; dabei können zwei oder mehrere Reste R⁵ bis R¹⁰ miteinander auch ein weiteres mono- oder polycyclisches, aliphatisches Ringsystem bilden;
- X: ist bei jedem Auftreten gleich oder verschieden -CR¹¹=CR¹¹-, -C≡C- oder -(NY)-;
- Y: ist bei jedem Auftreten gleich oder verschieden ein aromatisches oder heteroaromatisches Ringsystem mit 2 bis 60 C-Atomen, welches durch einen oder mehrere Reste R¹¹ substituiert oder unsubstituiert sein kann;
- R¹¹: ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch O, S, O-CO-O, CO-O, -CH=CH-, -C≡C- ersetzt sein können und in der auch ein oder mehrere H-Atome durch F, Cl, Br, I oder CN ersetzt sein können, oder eine Aryl-, Heteroaryl-, Aryloxy- oder Heteroaryloxygruppe mit 5 bis 40 C-Atomen, welche auch durch einen oder mehrere nicht-aromatische Reste R¹¹ substituiert sein kann; dabei können auch zwei oder mehrere der Reste R¹¹ miteinander und/oder mit R¹ bis R¹⁰ ein Ringsystem bilden;
- n: ist bei jedem Auftreten gleich oder verschieden 0 oder 1;
- m: ist bei jedem Auftreten gleich oder verschieden 0, 1, 2, 3 oder 4, mit der Maßgabe, dass mindestens ein Index m ungleich 0 ist;
mit der Maßgabe, dass mindestens zwei der Substituenten R¹ bis R⁴ ungleich H sind, wenn die Verbindung gemäß Formel (1) ein Tetrahydropyren-System darstellt.

Unter einem aromatischen oder heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische oder heteroaromatische Gruppen durch eine kurze, nicht aromatische Einheit (weniger als 10 % der von H verschiedenen Atome, bevorzugt weniger als 5 % der von H verschiedenen Atome), wie z. B. ein sp³-hybridisiertes C-Atom, unterbrochen sein können. So sollen also beispielsweise auch Systeme wie 9,9'-Spirobifluoren, 9,9-Diarylfluoren, etc. als aromatische Ringsysteme im Sinne dieser Anmeldung verstanden werden. Ebenso werden von diesem Begriff selbstverständlich auch einfache oder kondensierte Aromaten, wie beispielsweise Phenyl, Naphthyl, Anthryl, etc., oder miteinander verknüpfte Aromaten, wie beispielsweise Biphenyl, Binaphthyl, etc., mit umfasst. Der Begriff aromatisches Ringsystem soll jedoch keine Triarylamin-Gruppe umfassen.

Im Rahmen der vorliegenden Erfindung werden unter einer C₁ bis C₄₀ Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, n-Pentyl, s-Pentyl, Cyclopentyl, n-Hexyl, Cyclohexyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Octenyl, Cyclooctenyl, Ethinyl, Propinyl, Butinyl, Pentinyl, Hexinyl oder Octinyl verstanden. Unter einer C₁ bis C₄₀ Alkoxygruppe werden besonders bevorzugt Methoxy, Ethoxy, n-Propoxy, i-Propoxy, n-Butoxy, i-Butoxy, s-Butoxy oder t-Butoxy verstanden. Unter einem C₄-C₄₀ aromatischen oder heteroaromatischen Ringsystem werden besonders bevorzugt Phenyl, Biphenyl, Naphthyl, Anthracenyl, Triphenylenyl, [1,1';3',1"]Terphenyl-2'-yl, Binaphthyl, Phenanthrenyl, Fluorenyl, Spirobifluorenyl, Dihydrophenanthrenyl, Dihydropyrenyl, Tetrahydropyrenyl, 2-Pyridyl, 3-Pyridyl, 4-Pyridyl, Chinolinyl, Isochinolinyl, Chinoxalinyl, Acridinyl, Benzochinolinyl, Benzoisochinolinyl, 2-Thienyl, 3-Thienyl, 2-Furanyl, 3-Furanyl, 2-Pyrrolyl, 3-Pyrrolyl, Indolyl, lsoindolyl, Pentafluorophenyl, Tetrafluorophenyl, 3,5-Bistrifluoromethylphenyl, Heptafluoronaphthyl, o-Tolyl, m-Tolyl, p-Tolyl, 2,6-Dimethylphenyl, 2,6-Diethylphenyl, 2,6-Di-i-propylphenyl, 2,6-Di-t-butylphenyl, o-t-Butylphenyl, m-t-Butylphenyl oder p-t-Butylphenyl verstanden, die auch durch die oben genannten Reste substituiert sein können.

Auch wenn dies aus der obigen Beschreibung hervorgeht, sei hier nochmals explizit erwähnt, dass zwei oder mehrere Reste R⁵ bis R¹⁰ in Formel (1) auch miteinander ein weiteres aliphatisches.Ringsystem bilden können. Dies gilt insbesondere für die Substituenten R⁷ und R⁸, die bei Bildung eines weiteren 6-Ringsystems zur Ausbildung eines Dihydropyren-Systems bzw. Tetrahydropyren-Systems führen.

Bevorzugt sind organische Elektrolumineszenzvorrichtungen, bei denen für Verbindungen gemäß Formel (1) gilt:
- R¹, R³: ist bei jedem Auftreten gleich oder verschieden H, F, eine geradkettige, verzweigte oder cyclische Alkylkette mit 1 bis 10 C-Atomen, die durch R¹¹ substituiert sein kann, in der auch ein oder mehrere H-Atome durch F, Cl, Br, I oder CN ersetzt sein können, oder ein aromatisches oder heteroaromatisches Ringsystem mit 4 bis 40 C-Atomen, welches auch durch einen oder mehrere Reste R¹¹ substituiert sein kann; mit der Maßgabe, dass mindestens einer der beiden Reste R¹ und R³ ungleich H ist;
- R², R⁴: ist bei jedem Auftreten gleich oder verschieden dem bevorzugten R¹; oder R² und R⁴ stehen nicht für Substituenten, sondern bilden miteinander eine π-Bindung, so dass sich statt des Dihydrophenanthren-Systems ein Phenanthren-System ergibt;
- R⁵, R⁶, R⁷, R⁸, R⁹, R¹⁰: ist bei jedem Auftreten gleich oder verschieden H, F, eine geradkettige, verzweigte oder cyclische Alkylkette mit 1 bis 40 C-Atomen, bevorzugt mit 1 bis 10 C-Atomen, die durch R¹¹ substituiert sein kann, in der auch ein oder mehrere H-Atome durch F ersetzt sein können, oder ein aromatisches oder heteroaromatisches Ringsystem mit 4 bis 40 C-Atomen, welches auch durch einen oder mehrere Reste R¹¹ substituiert sein kann; dabei können zwei oder mehrere Reste R⁵ bis R¹⁰ miteinander auch ein weiteres mono- oder polycyclisches, aliphatisches Ringsystem bilden;
- X: ist bei jedem Auftreten gleich oder verschieden -CR¹¹=CR¹¹-, -C≡C- oder -(NY)-;
- Y: ist bei jedem Auftreten gleich oder verschieden ein aromatisches oder heteroaromatisches Ringsystem mit 6 bis 40 C-Atomen, welches durch einen oder mehrere Reste R¹¹ substituiert oder unsubstituiert sein kann;
- R¹¹: ist wie oben beschrieben;
- n: ist wie oben beschrieben;
- m: ist bei jedem Auftreten 1, 2, 3 oder 4.

Besonders bevorzugt sind organische Elektrolumineszenzvorrichtungen, bei denen für Verbindungen gemäß Formel (1) gilt:
- R¹, R³: ist bei jedem Auftreten gleich oder verschieden F, eine geradkettige oder verzweigte Alkylkette mit 1 bis 4 C-Atomen, in der auch ein oder mehrere H-Atome durch F oder CN ersetzt sein können, oder ein aromatisches oder heteroaromatisches Ringsystem mit 4 bis 25 C-Atomen, welches auch durch einen oder mehrere Reste R¹¹ substituiert sein kann;
- R², R⁴: ist bei jedem Auftreten gleich oder verschieden dem bevorzugten R¹; oder R² und R⁴ stehen nicht für Substituenten, sondern bilden miteinander eine π-Bindung, so dass sich statt des Dihydrophenanthren-Systems ein Phenanthren-System ergibt;
- R⁵, R⁶, R⁷, R⁸, R⁹, R¹⁰: ist bei jedem Auftreten gleich oder verschieden H oder F; oder die Positionen R⁷ und R⁸ werden durch eine C(R¹¹)₂-C(R11)₂-Kette überbrückt;
- X: ist bei jedem Auftreten gleich oder verschieden -CH=CH-, -C≡C- oder -(NY)-;
- Y: ist bei jedem Auftreten gleich oder verschieden ein aromatisches oder heteroaromatisches Ringsystem mit 10 bis 25 C-Atomen, welches durch einen oder mehrere Reste R¹¹ substituiert oder unsubstituiert sein kann;
- R¹¹: ist wie oben beschrieben;
- n, m: ist wie oben beschrieben.

Besonders bevorzugt enthält mindestens einer der Substituenten Y mindestens ein kondensiertes polycyclisches aromatisches Ringsystem, insbesondere Naphthalin, Anthracen, Phenanthren, Pyren, Dihydropyren, Chrysen, Naphthacen, Pentacen oder Perylen, ganz besonders bevorzugt Naphthalin, Anthracen, Phenanthren oder Pyren, oder mindestens einen Azaheterocyclus, insbesondere Pyridin, Pyrazin, Pyrimidin, Pyridazin, Chinolin, Isochinolin, Chinoxalin oder Phenanthrolin.

Weiterhin bevorzugt sind Verbindungen gemäß Formel (1), in denen die beiden Substituenten R¹ und R³ gleich sind. Ebenso bevorzugt sind Verbindungen gemäß Formel (1), in denen die beiden Substituenten R² und R⁴ gleich sind oder miteinander eine π-Bindung bilden. Ebenso bevorzugt sind Verbindungen gemäß Formel (1), in denen die beiden Substituenten [Y-[X]ₙ]ₘ- gleich gewählt sind. Besonders bevorzugt sind Verbindungen, die symmetrisch aufgebaut sind, in denen also beide Substituenten R¹ und R³ gleich gewählt sind und in denen beide Substituenten R² und R⁴ gleich gewählt sind oder miteinander eine Bindung bilden und in denen beide Substituenten [Y-[X]ₙ]ₘ- gleich gewählt sind.

Abhängig von der Verwendung der Verbindungen gemäß Formel (1) gelten weiterhin folgende Bevorzugungen:
Bei Verwendung der Verbindungen gemäß Formel (1) als Host-Material gilt bevorzugt n = 0.
Bei Verwendung der Verbindungen gemäß Formel (1) als emittierende Verbindungen (Dotanden) gilt bevorzugt, dass mindestens ein n = 1 ist, wobei das entsprechende m dann = 1, 2, 3 oder 4 ist, und dass mindestens ein X = -CR¹¹ =CR¹¹- oder -C≡C- ist; besonders bevorzugt sind beide n = 1 und beide m = 1, 2, 3 oder 3 und X hat die oben beschriebene Bedeutung.
Bei Verwendung der Verbindungen gemäß Formel (1) als Lochtransportverbindung gilt bevorzugt, dass mindestens ein n = 1 ist, wobei das entsprechende m dann = 1, 2, 3 oder 4 ist, und dass mindestens ein X = N-Y ist; besonders bevorzugt sind beide n = 1 und beide m = 1, 2, 3 oder 4 und X hat die oben beschriebene Bedeutung.

Abhängig von der Verarbeitungsweise der Verbindungen gemäß Formel (1) sind für den Index m verschiedene Werte bevorzugt. Wird die Verbindung in Vakuumaufdampfverfahren aufgebracht, so ist der Index m bevorzugt 1 oder 2. Wird die Verbindung bevorzugt aus Lösung und/oder durch Druckverfahren aufgebracht, so kann der Index m auch bevorzugt 3 oder 4 sein.

Die erfindungsgemäßen Verbindungen lassen sich leicht aus den entsprechenden bekannten 2,7-Dibromphenanthren-Derivaten bzw. den entsprechenden Dihydrophenanthren-, Dihydropyren- oder Tetrahydropyren-Derivaten durch metallkatalysierte Kupplungsreaktionen, insbesondere Kupplung gemäß Suzuki, Kupplung gemäß Hartwig-Buchwald und Kupplung gemäß Heck, herstellen. Die Synthese der Dihydrophenanthren-Vorstufen bzw. der Phenanthren-Vorstufen ist beispielsweise in den nicht offen gelegten Patentanmeldungen DE 10337346.2 und DE 102004020298.2 beschrieben.

Beispiele für bevorzugte Verbindungen gemäß Formel (1) sind die im Folgenden abgebildeten Beispiele 1 bis 21.

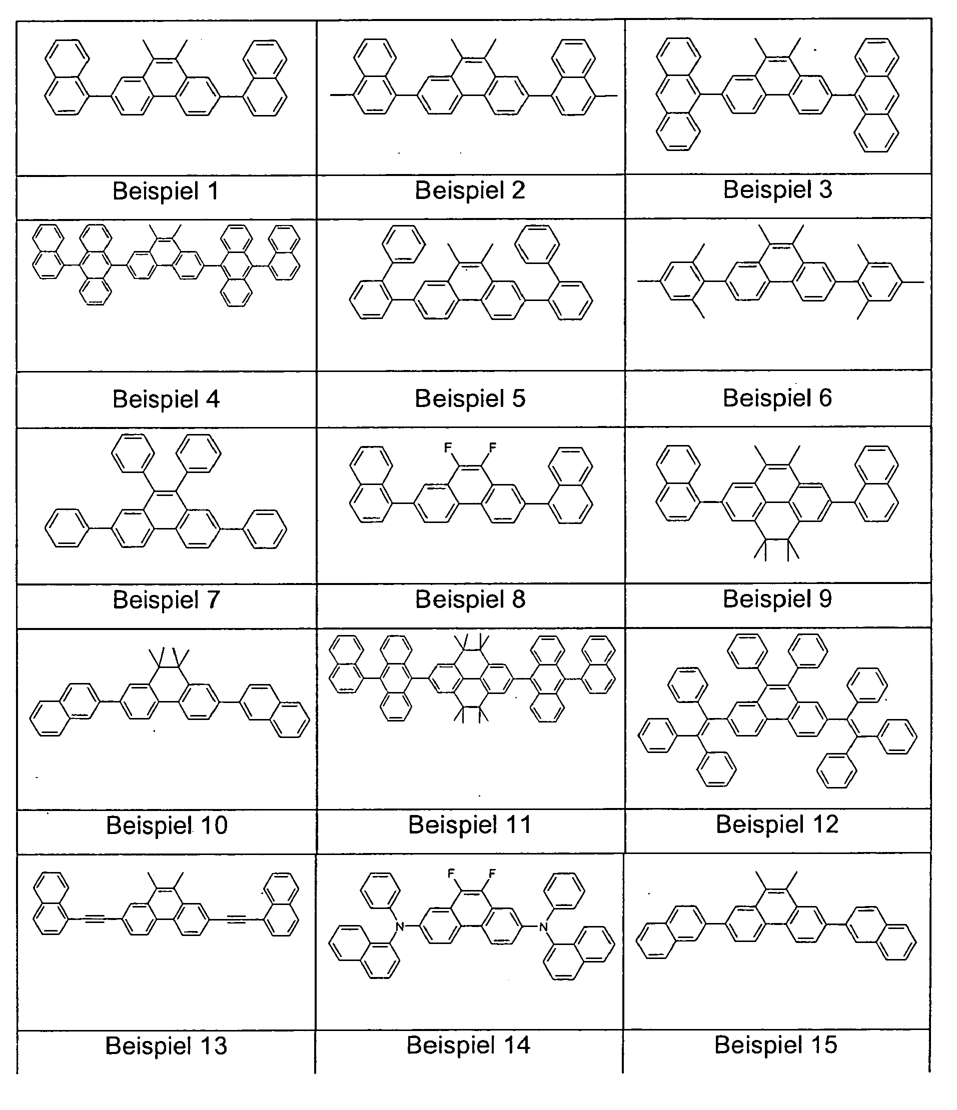

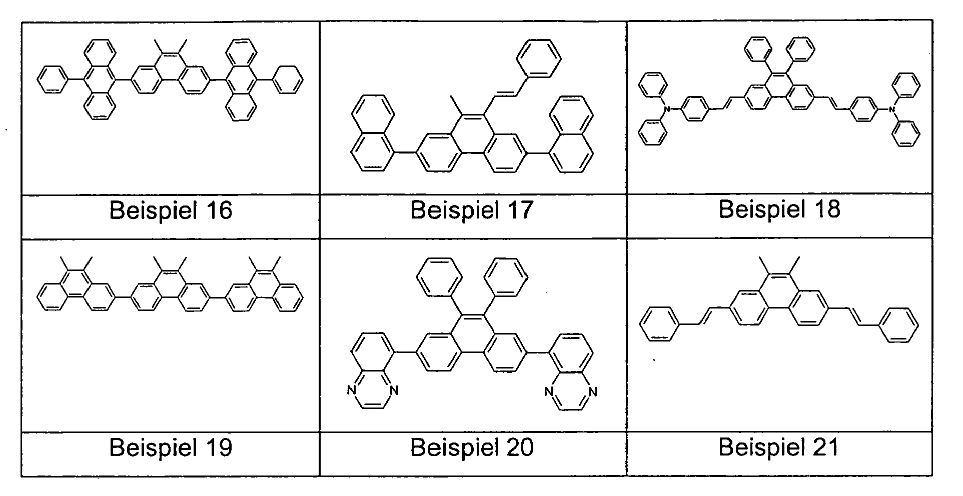

Die Verbindungen gemäß Formel (1) eignen sich besonders für die Verwendung in organischen Elektrolumineszenzvorrichtungen. Dabei wird die Verbindung bevorzugt in der emittierenden Schicht eingesetzt, entweder als Hostmaterial zusammen mit einem Dotanden oder, insbesondere bei geeigneter Substitution, als Dotand zusammen mit einem Hostmaterial. Ebenso bevorzugt wird die Verbindung als Lochtransportmaterial in einer Lochtransportschicht eingesetzt, insbesondere wenn mindestens einer der Substituenten eine Diarylamin-Gruppe darstellt. Ebenso bevorzugt wird die Verbindung als Elektronentransportmaterial in einer Elektronentransportschicht eingesetzt, insbesondere wenn mindestens einer der Substituenten einen elektronenarmen Aromaten enthält. Weiterhin bevorzugt wird die Verbindung als Lochblockiermaterial in einer Lochblockierschicht eingesetzt, insbesondere in phosphoreszierenden Elektrolumineszenzvorrichtungen.

Ein weiterer Gegenstand der vorliegenden Erfindung sind daher Mischungen aus einer Verbindung gemäß Formel (1) mit einem Dotanden, bzw. aus einer Verbindung gemäß Formel (1) mit einem Host-Material, wobei der Dotand überwiegend zur Emission beiträgt. Dabei kann der Dotand, mit dem die Verbindung gemäß Formel (1) gemischt ist, oder das Host-Material, mit dem die Verbindung gemäß Formel (1) gemischt ist, auch polymer sein.

Weiterer Gegenstand der Erfindung ist die Verwendung von Verbindungen gemäß Formel (1) in organischen elektronischen Vorrichtungen, insbesondere in organischen Elektrolumineszenzvorrichtungen, bevorzugt als Hostmaterial oder als emittierendes Material (Dotand).

Gegenstand der Erfindung sind somit ebenfalls organische elektronische Vorrichtungen, insbesondere organische Elektrolumineszenzvorrichtungen, mit einer oder mehreren aktiven Schichten, wobei mindestens eine dieser aktiven Schichten eine oder mehrere Verbindungen gemäß Formel (1) enthält. Die aktive Schicht kann beispielsweise eine lichtemittierende Schicht und/oder eine Ladungstransportschicht und/oder eine Ladungsinjektionsschicht sein, bevorzugt aber eine lichtemittierende Schicht.

Wenn die Verbindungen gemäß Formel (1) als Hostmaterial eingesetzt werden, sind bevorzugte Dotanden organische oder metallorganische Verbindungen, deren Emission längerwellig ist als die der Verbindung gemäß Formel (1). Dabei können Dotanden gewählt sein, die aus dem Singulett- oder aus dem Triplett-Zustand Licht emittieren. Besonders bevorzugte Dotanden, die aus dem Singulett-Zustand Licht emittieren, sind Verbindungen, die gleichzeitig eine oder mehrere gegebenenfalls substituierte Stilben-Einheiten und eine oder mehrere Triarylamin-Einheiten aufweisen. Besonders bevorzugte Dotanden, die aus dem Triplett-Zustand Licht emittieren, sind ortho-metallierte Iridium-Komplexe und Platin-Komplexe.

Der Anteil der Verbindung gemäß Formel (1) in der Mischung beträgt zwischen 1 und 99.9 Gew.%, bevorzugt zwischen 50 und 99.5 Gew.%, besonders bevorzugt zwischen 80 und 99 Gew.%, insbesondere zwischen 90 und 99 Gew.%, wenn die Verbindung gemäß Formel (1) als Host-Material verwendet wird.
Der Anteil der Verbindung gemäß Formel (1) in der Mischung beträgt zwischen 0.1 und 99 Gew.%, bevorzugt zwischen 0.5 und 50 Gew.%, besonders bevorzugt zwischen 1 und 20 Gew.%, insbesondere zwischen 1 und 10 Gew.%, wenn die Verbindung gemäß Formel (1) als Dotand verwendet wird.

Die organische Elektrolumineszenzvorrichtung enthält außer der emittierenden Schicht noch Anode und Kathode und kann noch weitere Schichten enthalten. Diese können beispielsweise sein: Lochinjektionsschicht, Lochtransportschicht, Lochblockierschicht, Elektronentransportschicht und/oder Elektroneninjektionsschicht. Es sei aber an dieser Stelle darauf hingewiesen, dass nicht notwendigerweise jede dieser Schichten vorhanden sein muss.
So werden insbesondere bei Verwendung von Verbindungen gemäß Formel (1) als Host weiterhin sehr gute Ergebnisse erhalten, wenn die organische Elektrolumineszenzvorrichtung keine separate Lochblockier- und/oder Elektronentransportschicht enthält und die emittierende Schicht direkt an die Elektroneninjektionsschicht oder an die Kathode grenzt. Ebenfalls kann es bevorzugt sein, wenn die organische Elektrolumineszenzvorrichtung keine separate Lochtransportschicht enthält und die emittierende Schicht direkt an die Lochinjektionsschicht oder an die Anode grenzt, insbesondere wenn die Verbindung gemäß Formel (1) mit mindestens einer Diarylaminogruppe substituiert ist. Weiterhin kann es bevorzugt sein, wenn Verbindungen gemäß Formel (1) in mehr als einer Schicht verwendet werden. So können diese Verbindungen beispielsweise nicht nur in der emittierenden Schicht, sondern auch zusätzlich in der Lochblockierschicht oder in der Elektronentransportschicht oder bei entsprechender geeigneter Substitution auch in der Lochtransportschicht verwendet werden.

Weiterhin bevorzugt ist eine organische Elektrolumineszenzvorrichtung, dadurch gekennzeichnet, dass eine oder mehrere Schichten mit einem Sublimationsverfahren bei einem Druck kleiner 10⁻⁵ mbar, bevorzugt kleiner 10⁻⁶ mbar, besonders bevorzugt kleiner 10⁻⁷ mbar, oder mit dem OVPD (Organic Vapour Phase Deposition) Verfahren oder mit Hilfe einer Trägergassublimation bei einem Druck zwischen 10⁻⁵ mbar und 1 bar oder aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck) oder Ink-Jet Druck (Tintenstrahl-Druck), beschichtet werden.

Die oben beschriebenen emittierenden Vorrichtungen weisen folgende überraschende Vorteile gegenüber dem Stand der Technik auf:
1. Die Emission von Verbindungen gemäß Formel (1) ist tiefer blau als von Phenanthren-Derivaten gemäß dem Stand der Technik, die in den 3,6-Positionen statt in den 2,7-Positionen substituiert sind. Daher sind diese Verbindungen besser als Host-Materialien für blaue Emission geeignet.
2. Die Effizienz entsprechender Vorrichtungen ist höher im Vergleich zu Systemen gemäß dem Stand der Technik.
3. Die Stabilität entsprechender Vorrichtungen ist höher im Vergleich zu Systemen gemäß dem Stand der Technik, was sich vor allem in einer deutlich höheren Lebensdauer zeigt.
4. Die Betriebsspannung wird verringert. Dadurch erhöht sich die Leistungseffizienz. Dies gilt insbesondere, wenn eine Verbindung gemäß Formel (1) als Host-Material mit einem Stilbenamin als fluoreszierendem Dotanden oder mit einem lridiumkomplex als phosphoreszierendem Dotanden verwendet wird.
5. Die Verbindungen gemäß Formel (1) sind leicht synthetisch zugänglich und können ohne Probleme auch im großen Maßstab hergestellt werden.
6. Die Verbindungen sind besser löslich als Phenanthren-Derivate, die gemäß dem Stand der Technik in organischen elektronischen Vorrichtungen verwendet werden und die keine Substitution in den 9,10-Positionen aufweisen. Dadurch lassen sie sich leichter reinigen, was einen erheblichen technischen Vorteil darstellt.

Im vorliegenden Anmeldetext und auch in den im Weiteren folgenden Beispielen wird auf die Verwendung erfindungsgemäßer Verbindungen in Bezug auf OLEDs und die entsprechenden Displays abgezielt. Trotz dieser Beschränkung der Beschreibung ist es für den Fachmann ohne weiteres erfinderisches Zutun möglich, die erfindungsgemäßen Verbindungen auch für weitere Verwendungen in anderen elektronischen Devices (Vorrichtungen) zu benutzen, z. B. für organische Feld-Effekt-Transistoren (O-FETs), organische Dünnfilmtransistoren (O-TFTs), organische integrierte Schaltungen (O-ICs), organische Solarzellen (O-SCs) oder auch organische Laserdioden (O-Laser), um nur einige Anwendungen zu nennen. Die Verwendung der erfindungsgemäßen Verbindungen in den entsprechenden Vorrichtungen ebenso wie diese Vorrichtungen selbst sind ebenfalls ein Gegenstand der vorliegenden Erfindung.
Die Erfindung wird durch die nachfolgenden Beispiele näher erläutert, ohne sie dadurch einschränken zu wollen.

### Beispiele:

Die nachfolgenden Synthesen wurden, sofern nicht anders angegeben, unter einer Schutzgasatmosphäre durchgeführt. Die Edukte wurden von den Fa. ALDRICH bzw. ABCR (4-Methylnaphthalin-1-boronsäure, Palladium(II)acetat, Tri-o-tolylphosphin, Anorganika, Lösemittel) bezogen. Die Synthese von 2,7-Dibrom-9,1 0-dimethylphenanthren wurde bereits in der nicht offen gelegten Patentanmeldung DE 102004020298.2 beschrieben.

### Beispiel 1: Synthese des Phenanthren-Derivats P1

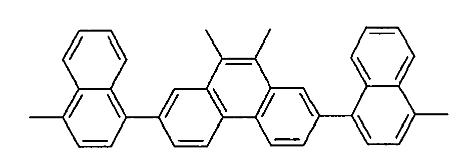

Eine entgaste, gut gerührte Suspension von 37.2 g (200 mmol) 4-Methylnaphtalin-1-boronsäure, 18.0 g (50 mmol) 9,10-Dimethyl-2,7-dibrom-phenanthren, 52.2 g (210 mmol) Kaliumphosphat-1-Hydrat in einem Gemisch aus 75 ml Dioxan, 150 ml Toluol und 200 ml Wasser wurde mit 457 mg (1.5 mmol) Tri-o-tolylphosphin und dann mit 56 mg (0.25 mmol) Palladium(II)acetat versetzt. Nach 16 h Erhitzen unter Rückfluss und Erkalten der Reaktionsmischung wurde der ausgefallene Feststoff abgesaugt, dreimal mit je 100 ml Wasser und dreimal mit je 100 ml Ethanol gewaschen. Nach Trocknen im Vakuum (1 mbar, 80 °C, 16 h) wurde das Produkt in einem Soxhlett-Extraktor mit Chloroform durch eine Glasfaserextraktionshülse (Porengröße 0.5 µm) extrahiert, um Palladiumspuren zu entfernen. Das nach Einengen des Chloroforms verbliebene Produkt wurde dreimal aus Chlorbenzol (ca. 25 ml/g) und dreimal aus DMF (ca. 60 ml/g) umkristallisiert, und anschließend zweimal im Hochvakuum (p = 5 x 10⁻⁵ mbar, T = 320 - 330 °C) sublimiert. Die Ausbeute bei einer Reinheit von 99.9 % nach HPLC betrug 15.6 g (32 mmol), entsprechend 64.2 % der Theorie.
¹H-NMR (TCE-d2): δ [ppm] = 8.87 (d, ³J_{HH} = 8.6 Hz, 2H, H4-Phen), 8.27 (d, ⁴J_{HH} = 1.5 Hz, 2H, H1-Phen), 8.13 (d, ³J_{HH} = 8.5 Hz, 2H, H-Naphth), 8.04 (d, ³J_{HH} = 8.5 Hz, 2H, H-Naphth), 7.81 (dd, ³J_{HH} = 8.6 Hz, ⁴J_{HH} = 1.5 Hz, 2H, H3-Phen), 7.60 (m, 2H), 7.54 - 7.47 (m, 6H), 2.80 (s, CH₃, 6H), 2.76 (s, CH₃, 6H).

### Beispiel 2: Löslichkeitsvergleich

Das Phenanthren-Derivat-P1, enthaltend Methylgruppen in 9- und 10-Position am Phenanthren, zeichnet sich durch eine mäßige bis gute Löslichkeit in gängigen organischen Lösungsmitteln aus, wodurch es sich leicht durch Umkristallisation reinigen läßt (s. Beispiel 1).
Dagegen sind strukturell analoge, aber in 9- und 10-Position unsubstituierte Phenanthrene in organischen Lösungsmitteln deutlich schlechter löslich. Dies führt zu erheblichen Problemen bei der Reinigung, da dazu wesentlich größere Apparate und deutlich größere Lösemittelmengen benötigt werden.

### Beispiel 3: Emission bei 3,6- und bei 2,7-substituierten Phenanthrenen

Die elektronischen Eigenschaften einiger 3,6- und 2,7-substituierter Phenanthrene wurden durch quantenchemische Berechnung bestimmt. Die Geometrien wurden im Grundzustand semi-empirisch optimiert. Die HOMO- und LUMO-Werte wurden durch DFT (Dichte Funktional Theorie) Rechnung (B3PW91/6-31g(d)) ermittelt. Alle Berechnungen wurden mit dem Gaussian 98 Programmpaket durchgeführt.

In Tabelle 1 werden die berechneten HOMO- und LUMO-Lagen, sowie der Bandgap für 3,6- und 2,7-dinaphthylsubstituierte Phenanthrene gegenübergestellt. Wie man diesen Zahlenwerten entnehmen kann, ist der Bandgap für 2,7-dinaphthylsubstituierte Phenanthrene um mehr als 0.1 eV größer als für die entsprechenden 3,6-substituierten Verbindungen, was zeigt, dass die erfindungsgemäßen Verbindungen besser als Host-Materialien für blau emittierende Dotanden geeignet sind als Verbindungen gemäß dem Stand der Technik.

**Tabelle 1: Vergleich zwischen 2,7- und 3,6-disubstituierten Phenanthrenen**

| Verbindung | HOMO [eV] | LUMO [eV] | Bandgap [eV] |
|---|---|---|---|
| 2,7-Bis(1-naphthyl)phenanthren | -5.90 | -2.43 | 3.47 |
| 3,6-Bis(1-naphthyl)phenanthren | -5.78 | -2.43 | 3.35 |
| 2,7-Bis(4-methyl-1-naphthyl)phenanthren | -5.80 | -2.39 | 3.41 |
| 3,6-Bis(4-methyl-1-naphthyl)phenanthren | -5.69 | -2.39 | 3.30 |

## Patentansprüche

1. Verbindungen gemäß Formel (1), 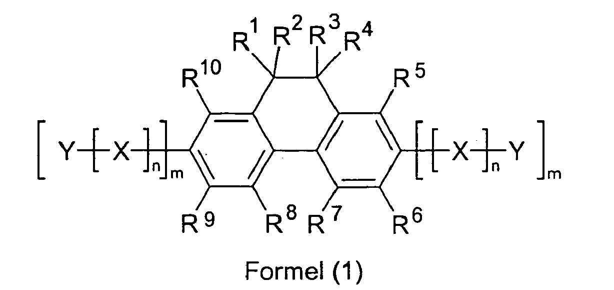 wobei die verwendeten Symbole und Indizes folgende Bedeutung besitzen:
R¹, R³ ist bei jedem Auftreten gleich oder verschieden H, F, eine geradkettige, verzweigte oder cyclische Alkyl- oder Alkoxykette mit 1 bis 40 C-Atomen, die durch R¹¹ substituiert sein kann, in der auch ein oder mehrere nicht benachbarte C-Atome durch N-R¹¹, O, S, O-CO-O, CO-O, -CR¹¹=CR¹¹- oder -C≡C- ersetzt sein können und in der auch ein oder mehrere H-Atome durch F, Cl, Br, l oder CN ersetzt sein können, oder ein aromatisches oder heteroaromatisches Ringsystem mit 2 bis 60 C-Atomen, welches auch durch einen oder mehrere Reste R¹¹ substituiert sein kann; mit der Maßgabe, dass mindestens einer der beiden Reste R¹ und R³ ungleich H ist;
R², R⁴ ist bei jedem Auftreten gleich oder verschieden R¹, oder R² und R⁴ stehen nicht für Substituenten, sondern bilden miteinander eine Bindung, so dass sich statt des Dihydrophenanthren-Systems ein Phenanthren-System ergibt;
R⁵, R⁶, R⁷, R⁸, R⁹, R¹⁰ ist bei jedem Auftreten gleich oder verschieden H, F, Cl, Br, I, eine geradkettige, verzweigte oder cyclische Alkyl- oder Alkoxykette mit 1 bis 40 C-Atomen, die durch R¹¹ substituiert sein kann, in der auch ein oder mehrere nicht benachbarte C-Atome durch N-R¹¹, O, S, O-CO-O, CO-O, -CR¹¹=CR¹¹- oder -C≡C- ersetzt sein können und in der auch ein oder mehrere H-Atome durch F, Cl, Br, l oder CN ersetzt sein können, oder ein aromatisches oder heteroaromatisches Ringsystem mit 2 bis 60 C-Atomen, welches auch durch einen oder mehrere Reste R¹¹ substituiert sein kann; dabei können zwei oder mehrere Reste R⁵ bis R¹⁰ miteinander auch ein weiteres mono- oder polycyclisches Ringsystem bilden;
X ist bei jedem Auftreten gleich oder verschieden -CR¹¹=CR¹¹-, -C≡C- oder -(NY)-;
Y ist bei jedem Auftreten gleich oder verschieden ein aromatisches oder heteroaromatisches Ringsystem mit 2 bis 60 C-Atomen, welches durch einen oder mehrere Reste R¹¹ substituiert oder unsubstituiert sein kann;
R¹¹ ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch O, S, O-CO-O, CO-O, -CH=CH-, -C≡C- ersetzt sein können und in der auch ein oder mehrere H-Atome durch F, Cl, Br, l oder CN ersetzt sein können, oder eine Aryl-, Heteroaryl-, Aryloxy- oder Heteroaryloxygruppe mit 5 bis 40 C-Atomen, welche auch durch ein oder mehrere nicht-aromatische Reste R¹¹ substituiert sein kann; dabei können auch zwei oder mehrere der Reste R¹¹ miteinander und/oder mit R¹ bis R¹⁰ ein Ringsystem bilden;
n ist bei jedem Auftreten gleich oder verschieden 0 oder 1;
m ist bei jedem Auftreten gleich oder verschieden 0, 1, 2, 3 oder 4, mit der Maßgabe, dass mindestens ein Index m ungleich 0 ist;
mit der Maßgabe, dass mindestens zwei der Substituenten R¹ bis R⁴ ungleich H sind, wenn die Verbindung gemäß Formel (1) ein Tetrahydropyren-System darstellt.

2. Verbindungen gemäß Anspruch 1, worin für die Symbole und Indizes gilt:
R¹, R³ ist bei jedem Auftreten gleich oder verschieden H, F, eine geradkettige, verzweigte oder cyclische Alkylkette mit 1 bis 10 C-Atomen, die durch R¹¹ substituiert sein kann, in der auch ein oder mehrere H-Atome durch F, Cl, Br, I oder CN ersetzt sein können, oder ein aromatisches oder heteroaromatisches Ringsystem mit 4 bis 40 C-Atomen, welches auch durch einen oder mehrere Reste R¹¹ substituiert sein kann; mit der Maßgabe, dass mindestens einer der beiden Reste R¹ und R³ ungleich H ist;
R², R⁴ ist bei jedem Auftreten gleich oder verschieden dem bevorzugten R¹; oder R² und R⁴ stehen nicht für Substituenten, sondern bilden miteinander eine π-Bindung, so dass sich statt des Dihydrophenanthren-Systems ein Phenanthren-System ergibt;
R⁵, R⁶, R⁷, R⁸, R⁹, R¹⁰ ist bei jedem Auftreten gleich oder verschieden H, F, eine geradkettige, verzweigte oder cyclische Alkylkette mit 1 bis 40 C-Atomen, die durch R¹¹ substituiert sein kann, in der auch ein oder mehrere H-Atome durch F ersetzt sein können, oder ein aromatisches oder heteroaromatisches Ringsystem mit 4 bis 40 C-Atomen, welches auch durch einen oder mehrere Reste R¹¹ substituiert sein kann; dabei können zwei oder mehrere Reste R⁵ bis R¹⁰ miteinander auch ein weiteres mono- oder polycyclisches Ringsystem bilden;
X ist bei jedem Auftreten gleich oder verschieden -CR¹¹=CR¹¹-, -C≡C- oder -(NY)-;
Y ist bei jedem Auftreten gleich oder verschieden ein aromatisches oder heteroaromatisches Ringsystem mit 6 bis 40 C-Atomen, welches durch einen oder mehrere Reste R¹¹ substituiert oder unsubstituiert sein kann;
R¹¹ ist wie oben beschrieben;
n ist wie oben beschrieben;
m ist bei jedem Auftreten 1, 2, 3 oder 4.

3. Verbindungen gemäß Anspruch 1 und/oder 2, **dadurch gekennzeichnet, dass** mindestens einer der Substituenten Y mindestens ein kondensiertes polycyclisches aromatisches Ringsystem oder einen Azaheterocyclus enthält.

4. Verbindungen gemäß Anspruch 3, **dadurch gekennzeichnet, dass** das kondensierte polycyclische aromatische Ringsystem ausgewählt ist aus Naphthalin, Anthracen, Phenanthren, Pyren, Dihydropyren, Chrysen, Naphthacen, Pentacen, Perylen, Chinolin, Isochinolin, Chinoxalin oder Phenanthrolin.

5. Verbindungen gemäß einem oder mehreren der Ansprüche 1 bis 4, **dadurch gekennzeichnet, dass** die Verbindung symmetrisch aufgebaut ist.

6. Verbindungen gemäß einem oder mehreren der Ansprüche 1 bis 5, **dadurch gekennzeichnet, dass** für die Verwendung der Verbindung als Host-Material n = 0 gilt.

7. Verbindungen gemäß einem oder mehreren der Ansprüche 1 bis 5, **dadurch gekennzeichnet, dass** für die Verwendung der Verbindung als emittierendes Material (Dotand) mindestens ein n = 1 ist, wobei das entsprechende m = 1, 2, 3 oder 4 ist, und dass mindestens ein X = -CR¹¹=CR¹¹- oder -C≡C- ist.

8. Verbindungen gemäß einem oder mehreren der Ansprüche 1 bis 5, **dadurch gekennzeichnet, dass** für die Verwendung der Verbindung als Lochtransportmaterial mindestens ein n = 1 ist, wobei das entsprechende m = 1, 2, 3 oder 4 ist, und dass mindestens ein X = N-Y ist.

9. Verbindungen gemäß einem oder mehreren der Ansprüche 1 bis 8, **dadurch gekennzeichnet, dass** sie aus den Beispielstrukturen 1 bis 21 ausgewählt sind.

10. Mischungen aus mindestens einer Verbindung gemäß einem oder mehreren der Ansprüche 1 bis 9 mit entweder einem Hostmaterial oder mit einem Dotanden.

11. Verwendung von Verbindungen oder Mischungen gemäß einem oder mehreren der Ansprüche 1 bis 10 in organischen elektronischen Vorrichtungen, insbesondere in Elektrolumineszenzvorrichtungen.

12. Organische elektronische Vorrichtungen, enthaltend Anode, Kathode und mindestens eine Verbindung oder Mischung gemäß einem oder mehreren der Ansprüche 1 bis 10.

13. Organische elektronische Vorrichtung gemäß Anspruch 12, enthaltend eine Verbindung gemäß einem oder mehreren der Ansprüche 1 bis 9 als Hostmaterial zusammen mit einem Dotanden, der aus dem Singulett- oder aus dem Triplett-Zustand Licht emittieren kann, oder als Dotand zusammen mit einem Hostmaterial oder als Lochtransportmaterial.

14. Organische elektronische Vorrichtung gemäß Anspruch 12 und/oder 13, **dadurch gekennzeichnet, dass** es sich um eine organische Elektrolumineszenzvorrichtung (OLED), einen organischen Feld-Effekt-Transistor (O-FET), einen organischen Dünnfilmtransistor (O-TFT), eine organische integrierte Schaltung (O-IC), eine organische Solarzelle (O-SC) oder eine organische Laserdiode (O-Laser) handelt.
